# EUROPEAN PATENT SPECIFICATION

(11) **EP 1 269 808 B1**
(45) Date of publication and mention of the grant of the patent: **22.08.2007**
(21) Application number: 01916828.5
(22) Date of filing: 30.03.2001
(51) Int. Cl.: H05K 3/40, H05K 3/46

(54) **METHOD FOR FABRICATING ELECTRICAL CONNECTING ELEMENTS, AND CONNECTING ELEMENT**
VERFAHREN ZUR HERSTELLUNG ELEKTRISCHER VERBINDUNGSELEMENTE UND VERBINDUNGSELEMENT
PROCEDE DESTINE A LA FABRICATION D'ELEMENTS DE CONNEXION ELECTRIQUE, ET ELEMENT DE CONNEXION

(30) Priority: 31.03.2000 US 193370 P
(43) Date of publication of application: 02.01.2003
(73) Proprietor: Dyconex AG, 8303 Bassersdorf (CH)
(72) Inventor: SCHMIDT, Walter, CH-8332 Russikon (CH)
(74) Representative: Frei, Alexandra Sarah
(86) International application number: PCT/CH2001/000201
(87) International publication number: WO 2001/076336

(56) References cited:
- WO-A-00/13062
- WO-A-99/49708
- DE-A- 19 522 338
- US-A- 3 346 950
- US-A- 4 663 840
- US-A- 6 005 198
- PATENT ABSTRACTS OF JAPAN vol. 1997, no. 04, 30 April 1997 (1997-04-30) & JP 08 335783 A (TOSHIBA CORP), 17 December 1996 (1996-12-17)

## Description

The invention relates to methods for fabricating electrical connecting elements such as Printed Circuit Boards (PCBs). High-Density-Interconnects (HDIs). Ball-Grid-Array- (BGA-) substrates, Chip Scale Packages (CSP), Multi-Chip-Module- (MCM) substrates, etc. It also relates to an electrical connecting element or semifinished product, respectively.

In modem circuit board technology, due to increasing miniaturization, conventionally drilled through holes are more and more replaced by microvias. Methods for fabricating such microvias include laser drilling and plasma drilling as well as photochemical structuring. A new method for fabricating microvias has been disclosed in WO 00/13062. This new technology approach, the Micro-Perforation (MP), is a method including mechanical embossing of micro-holes into deformable dielectric material. With Micro-Perforation, any shape of a microvia is feasible. By controlling the length and size of perforation-tips also the formation of very small blind microvias can be achieved.

A micro-perforation process, as e.g, described in WO 00/13062, can be performed in two different modes: The sequential mode (SMP) and the parallel mode (PMP). When the PMP method is used, a die is produced first, which is pressed with high pressure and at elevated temperature onto the a possibly coated substrate. In a next step, the thus resulting semifinished product may be laminated onto a further semifinished product.

JP 08335783 discloses a method which includes pressing a laminated presser plate so that protrusions formed by a metal film pierces an insulator layer to abut against a conductor surface and to be connected electrically therewith. US 6,005,198 discloses a method of manufacturing a Printed Wiring Board which includes embossing cup shaped recesses and disposing conductor material within the recess.

It is an object of the present invention to further rationalize and simplify the production of electrical connecting elements based on this microperforation (MP) technology.

This object is achieved by the invention as defined in the claims.

The invention is essentially characterized in that a parallel microperforation (PMP) process step is combined with a lamination process step.

To this end, a prefabricated product and a second dielectric layer are placed between a support and a perforation die. The prefabricated product is partially covered by a conducting layer forming structures - such as conductor paths, contacting areas, shields, etc - to be contacted by microvias. Pressure is applied on the perforation die, perforation tips of the perforation die forming for the microvias. A surface of the dielectric layer or of the prefabricated product is configured or coated to stick to a surface of the other dielectric layer if pressure is applied on it.

The prefabricated product may be a prefabricated several-layer build up to which at least a further layer has to be added to form an electrical connecting element. It may also be a mere dielectric layer with at least one pre-structured conductor coating which has to be supplemented by further layers to form a PCB/HDI.

According to one embodiment of the invention, at least one of the dielectric layers and of the prefabricated product previous to the lamination/perforation step comprises an uncured dielectric. Temperature and pressure applied onto the layers during the combined lamination/perforation process are then high enough to cross link the material and cure it. The layer after lamination automatically sticks to the other dielectric layer.

According to an other embodiment of the invention, at least one of the prefabricated product and the dielectric layer comprises a thermoplastic foil, e.g. a Liquid Crystal Polymer (LCP) foil. In this case, the foil during the combined lamination/perforation step is softened and afterwards bonds to the other layer.

According to yet another embodiment of the invention, between the prefabricated product and the dielectric layer, a thin adhesive layer is present.

According to a further embodiment of the invention, the dielectric layer is a thin adhesive layer sticking to a conductor layer

The perforation die and the two coated dielectric layers may be guided by some alignment means during the perforation/lamination process step.

In the following, preferred embodiments of the invention are described with reference to drawings. In the drawings,
- Figures 1 a through 1g show a fabrication step according to the state of the art, and
- Figures 2a - 2g, 3a - 3g, 4a - 4g, 5a - 5g, and 6a - 6f schematically show process sequences of an example of a method according to the invention.

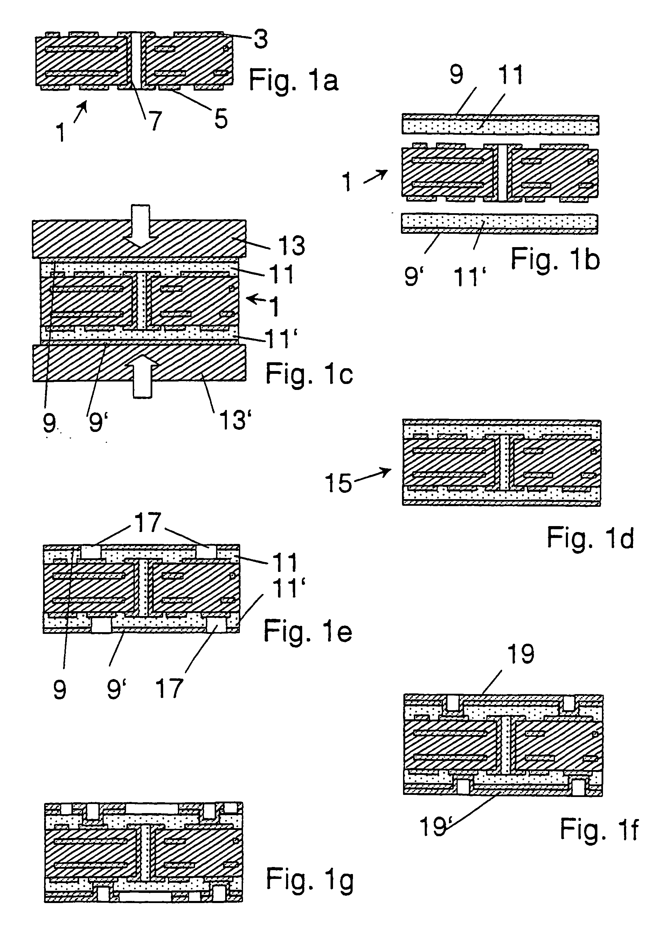

**In Figure 1a**, a traditionally manufactured Printed Circuit Board (PCB) 1 is shown. It comprises two outermost conductor layers 3, 5 which are structured, i.e. which comprise conductor paths, contact areas (pads) etc. Further, in the Figure a mechanically drilled and plated through hole 7 is shown.

According to **Figures 1b and 1c,** two additional copper foils 9, 9' coated with noncured adhesive 11, 11' are attached to the PCB, with the copper foils outside. In Figure 1c, two support plates 13, 13' of a lamination press are shown. In this heated lamination press, the package is pressed together. In this process, the adhesive cures and a new semi-finished product is formed.

This semifinished product 15 is shown in **Figure 1d. In Figure 1e,** holes 17 for microvias to conductor areas of the outermost layer of the prefabricated product 1 underneath are drilled in the copper foils 9, 9' and the cured adhesive 11. 11' by the use of lasers or by plasma ablation. The resulting product is then further plated by a copper layer 19, 19', by which process the microvias are finished (Figure If). Finally, the outermost layers are photochemically structured to generate the conductor paths, pads, etc. **(Figure 1g).**

This prior art method suffers from the drawback that many production steps are required, some of them sequential production steps.

With reference to the drawings 2a-6f, mainly the differences to the prior art method are described.

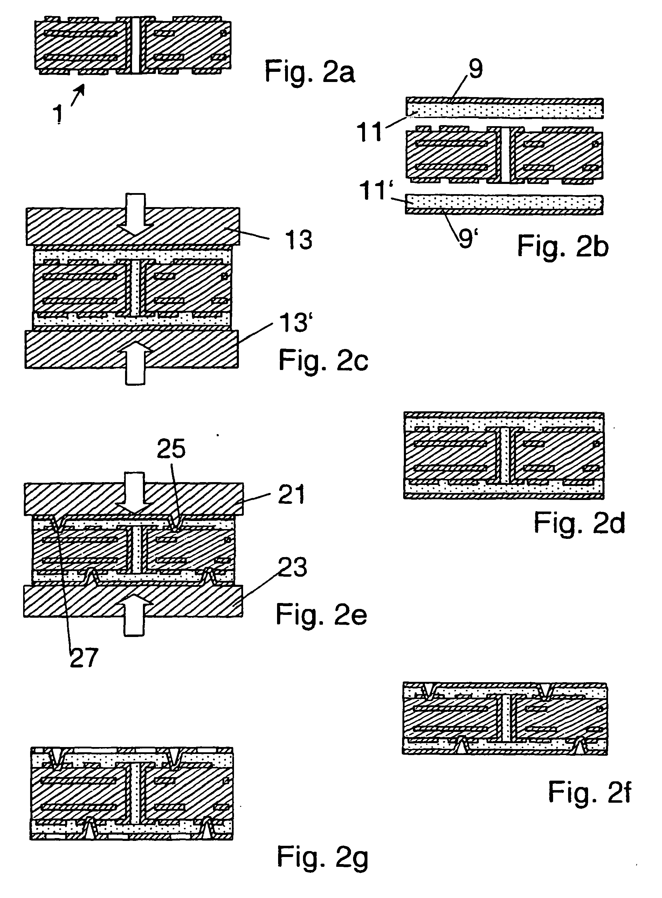

The prefabricated product 1 of **Figure 2a** may e.g. also be a conventionally manufactured PCB. As outlined above, however, this embodiment and also the below described embodiments of the method according to the invention work for any prefabricated product comprising a dielectric layer and a structured outermost conductor layer. E.g., the prefabricated product may be a HDI with microvias manufactured by micro-perforation. Then, in a first lamination cycle, two copper layers are laminated to the prefabricated product, as shown **Figures 2b,** 2c, and 2d. This first lamination cycle largely corresponds to the lamination process of Figures 1b-1d. The adhesive 11, 11' is cured until it forms a plastically deformable layer. After the first lamination cycle, the product is placed between two perforation dies 21, 23 or between a perforation die and a support, and pressure is applied **(Figure 2e).** By the perforation process, the copper material of the copper layers 9, 9' is deformed, the partially cured adhesive is thrust aside, and microvias 25 are created. The length of the perforation tips is about the sum of the thicknesses of a copper layer 9 and the adhesive layer 11. The shape of the perforation tips 27 and the dynamics, i.e. the speed of the perforation dies during the process (or the pressure applied, respectively) are chosen such that the perforation step results in a mere deformation of the copper layers 9, 9' and not in their piercing. By the pressure applied, the copper material of the layers 9, 9' and the conductor material of the pads underneath may be welded in a cold welding process. A detailed description of a perforation process combined with a cold welding process is described in an application ("Method and device for fabricating electrical connecting elements, and connecting element") of the same applicant based on the same priority. Temperature and pressure during this second lamination cycle are chosen so that the adhesive further undergoes a curing step, the perforation step thus being also a second lamination cycle. The product after this Step is shown in Figure 2f. A photo chemical structuring of the outermost layers follows **(Figure 2g).**

Due to the first lamination cycle, the dielectric layers 11. 11' are not liquid during the combined perforation/welding process. Thus, there is no risk that due to the pressures involved dielectric material gets to the surface through a imperfect perforation hole and soils the perforation die.

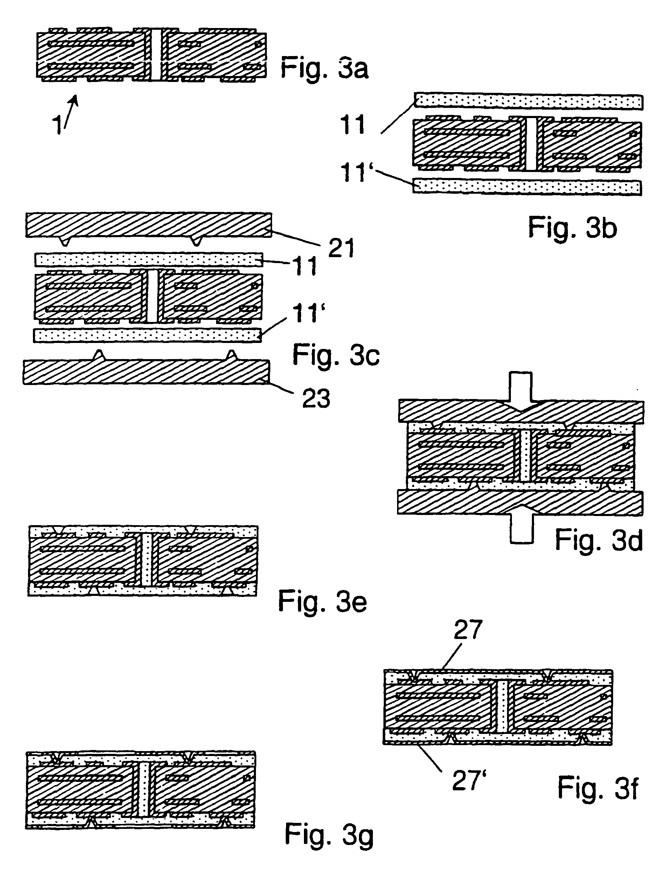

Also the prefabricated product 1 of **Figure 3a** may be a traditionally manufactured PCB with mechanically drilled and plated through holes. In **Figure 3b,** this PCB is sandwiched between two layers 11, 11' of adhesive. Then the stack, i.e. the prefabricated product with the adhesive layers 11, 11' is placed in a heated lamination press comprising two perforation dies 21, 23 or a perforation die and a support plate **(Figure 3c).** Both perforation dies are coated with a release layer During the lamination/perforation process shown in **Figure 3d,** the adhesive is cured and holes for microvias are formed simultaneously. Afterwards, the perforation tools 21, 23 are removed. This is possible without adhesive material sticking to them because of the release layer coating. The resulting product, shown in **Figure 3e,** is subsequently cleaned by plasma etching (optional) in order to remove electrically insulating residues from the places to be contacted. Then, both sides of the product are plated by additional copper layers 27, 27', as represented in **Figure 3f.** Finally, the outer layers 27, 27' are photo-chemically structured in a conventional way **(Figure 3g).**

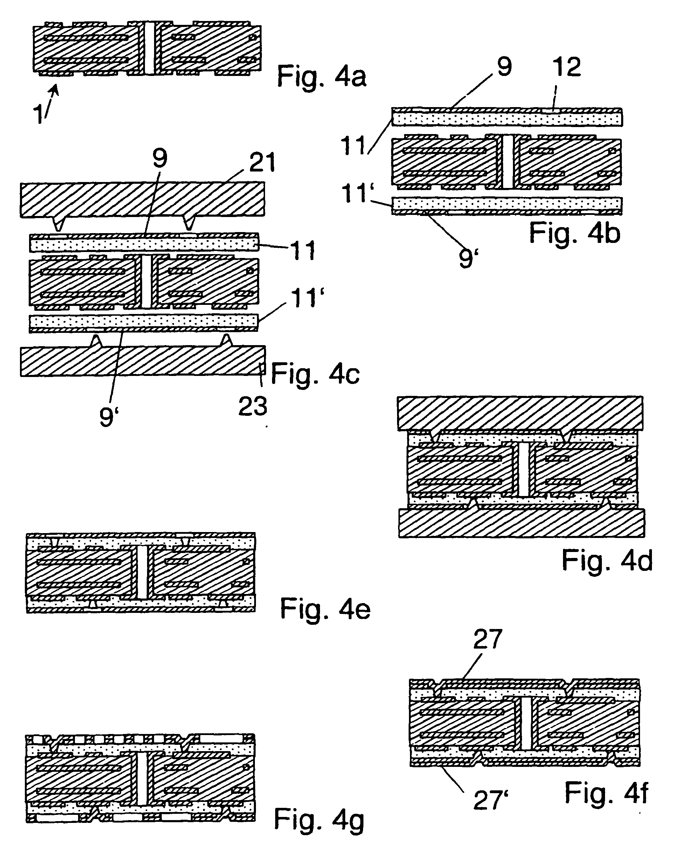

The embodiment of the method according to the invention described with reference to **Figures 4a-4g** is similar to the method described with reference to Figures 3a-3g. However, instead of only adhesion layers outermost copper layers 9, 9' coated with an adhesion layers 11, 11' are placed on the prefabricated product. The copper layers 9, 9' are pre-structured, so that openings 12 are present at the spots where microvias are to be formed. The holes formed in the perforation step (Figures 4c, 4d) are thus formed in the adhesion layer only. After the perforation/lamination step, the product is plasma cleaned, laminated and photo-structured analogously to Figures 3e-3g.

The embodiment described with reference to Figures 4a-4g can also be viewed as a modification of the method described with reference to Figures 2a-2g, however, the adhesive coated copper layers 9, 9' being photochemically pre-structured. Additionally, only one lamination cycle (corresponding to the second lamination cycle of Figures 2a-2g) may be made and after the perforation step, a plasma cleaning step is performed.

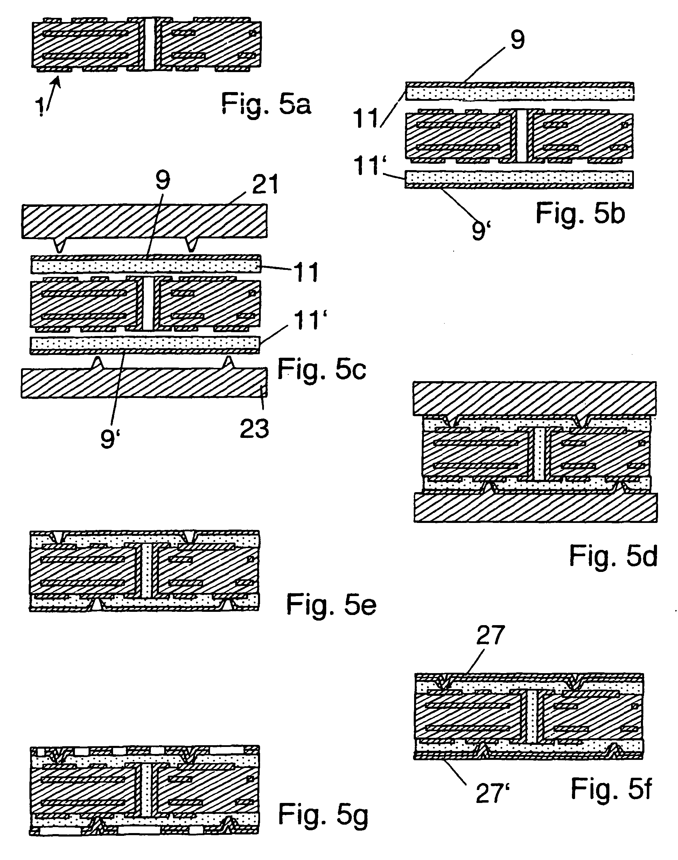

The embodiment shown in **Figures 5a-5g** is similar to the embodiment of Figures 4a-4g. However, the copper layers 9, 9' are not pre-structured. In contrast to the embodiment of Figures 2a-2g, however, the copper layers 9, 9' are pierced by the perforation tips, so that the outermost, structured conductor layers of the prefabricated product 1 are not or not reliably contacted by copper layers 9, 9'. To this end, the perforation tips e.g. comprise a sharp apex or a sharp edge. The behavior of the copper material during the perforation step (i.e. whether it is pierced or merely deformed) is also influenced by the dynamics and the thickness and consistency of the adhesion layer during the lamination process.

Also in the embodiments of Figures 3a-3g, 4a-4g and 5a-5g, the perforation/lamination step may be preceded by a first lamination cycle.

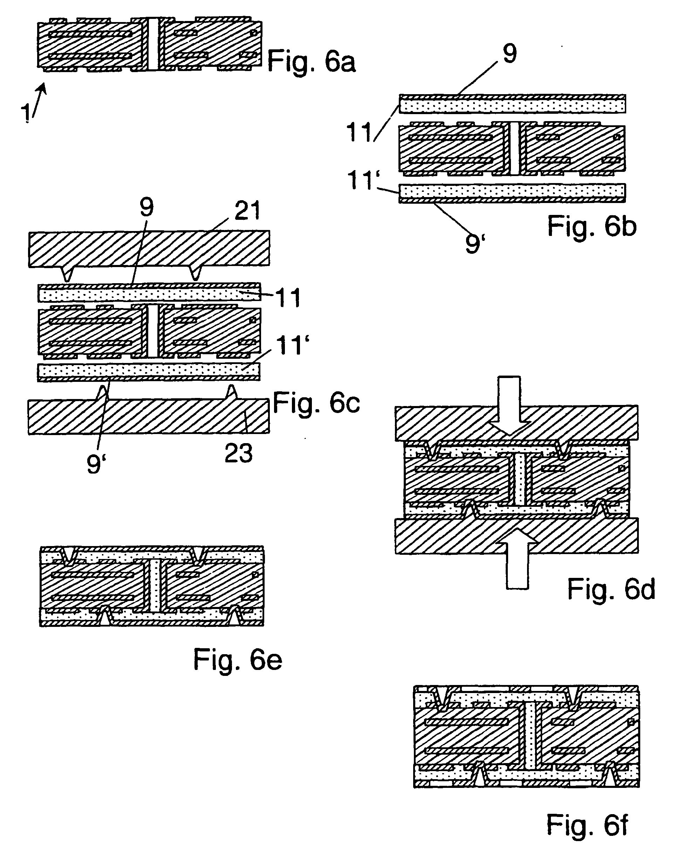

According to **Figure 6b,** two copper foils 9, 9' coated with adhesive layers 11. 11' are attached to the prefabricated product 1 shown in **Figure 6a.** Then, the lamination is performed in a lamination press, the press tools being perforation dies 21, 23 containing all perforation tips **(Figure 6c).** The lamination press is heated to a temperature at which the adhesive is cross-linked. During lamination, the perforation tips deform the copper on the outer Layers 9, 9' and simultaneously generate electrical contacts with the adjacent inner layers **(Figure 6d).** Like in the embodiment of Figures 2a-2g, the perforation tip shape and the perforation dynamics are chosen so that the copper material is not pierced and a cold welding process between the copper material of the outer layers 9, 9' and adjacent inner layers takes place. **Figure 6e** shows the product after lamination. The lamination process does the hole drilling for the microvias and at the same time generates the electrical connections between the layers, thus finishing the microvias. The surfaces do not have to be additionally laminated. As can be seen in **Figure 6f,** the outermost layers can be photochemically structured afterwards to form conductors, pads etc.

In order to show the differences between the different embodiments more clearly, in the above descriptions of examples of these embodiments, it is always referred to the same prefabricated product, namely a traditionally manufactured PCB, and to the same materials. It should be noted, however, that for all embodiments the whole variety of different possible prefabricated products may be started from. In addition, the materials of course may vary. Whereas the material of the outermost metallic layers in the above examples is copper or a copper alloy, of course also other conducting coating materials may be envisaged, e.g. silver or silver alloys.

The material of the adhesive layers 11, 11' may be a known adhesive layer used already in the state of the art PCB manufacturing processes. Such an adhesive layer may however, also be replaced by any known dielectric layer, possibly coated with a thin adhesive coating. Available materials include any dielectric material, e.g. duroplastic material such as an epoxy resin, polyimide, cyanate ester etc, or a thermoplastic material like an LCP (liquid crystal polymer) or any other thermoplastic material. It may further be a plastic foil, sheet or plate of any thickness, especially for the embodiments of Figs. 3a-3g, 4a-4g, and 5a-5.g. As an example, it may be a plastic foil having a thickness between 25 and 150 µm.

The method according to the invention does not rely on the simultaneous lamination of two dielectric (e.g. adhesive) layers. It can also be performed for the lamination of only one layer on one side of the prefabricated product.

The prefabricated product comprises a surface, only a part of which is built by a structured conducting layer. The dielectric material forming the rest of the surface may also comprise adhesion means. In general, lamination during the combined perforation/lamination process can be achieved by one or an appropriate combination of the following means:
(i) The dielectric layer is, previous to the step, an uncured dielectric. By the pressure arising during this step and by choosing the appropriate curing temperature, the material is cross-linked. This cross-linking results in a tight connection between dielectric layer and the prefabricated product. This set-up corresponds to the examples shown in the figures, where the dielectric layer is an adhesive layer.
(ii) The surface of the prefabricated product at least partially comprises an uncured dielelctric.
(iii) The dielectric layer and/or parts of the surface of the prefabricated product is/are made from a thermoplastic material. The temperature of the support and of the perforation die are then chosen so that the material is softened or melted. This softening may be supported by the pressure applied. After the step, the dielectric layer and the prefabricated product stick to each other.
(iv) An adhesive of the above kind is placed between the dielectric layer and the prefabricated product.

The perforation dies are e.g. formed as metal plates with a hard surface and with perforation tips. The shape of the perforation tips corresponds to the shape of the desired microvia and also depends on processing parameters, and on the fact whether the tips are to pierce the conductor layers or not. The lamination press may further comprise alignment means (not shown). These may e.g. be fixed to a support plate and be formed to guide the layers and the perforation tool during the perforation process.

For the perforation process, which is, according to the present invention carried out simultaneously to the lamination process and possibly also to a curing process, the tip shape of the perforation tips may be important, as outlined above. So far, for forming perforation dies mainly chemical etching methods have been used: A material block with a flat surface is provided with an etch resist with openings at places where tips are to be formed. Then, material is removed at these places by an etchant resulting in holes. After removal of the etch resist, the block surface then serves as negative form for a replication process by electro-forming. The disadvantage of this method is that the holes and consequently the resulting tips due to the production method are rather flat and the shape is poorly defined. In the following, a brief description of an exemplary production method of perforation dies by which every possible tip shape can be manufactured is shortly described.

A master tool comprises a mechanically manufactured tip made out of very hard materials such as, e.g., cemented carbide, sapphire or even diamond. It can be fabricated to have any desired shape. The master tool is mounted in a sequentially working perforation equipment. This equipment accepts the digital data normally used by mechanical drilling machines and produces very precisely defined intents into a soft material block, e.g. a copper or even a plastic block. The resulting negative form is then used for replication by an electro-forming process. Such an electro-forming process can e.g. comprise two steps. The first step then is providing the negative form with a hard metal coating layer, e.g. an about 100 µm thick layer of nickel. Afterwards, a relatively thick layer of an other material is applied. This layer together with the coating layer is afterwards removed from the negative form and used as perforation die.

Examples of tip shapes produced by this method include chisel-like shapes, very sharp tips, tips with cutting edges etc. If a cold welding process is to be achieved the tips are formed in special way in which, on a micrometer scale, no sharp tips or edges are present.

## Claims

1. A method for manufacturing electrical connecting elements or semifinished products wherein
a prefabricated product (1) having a first surface being partially covered by a structured electrically conducting layer and a dielectric layer (11, 11') comprising an electrically conductive layer (9, 9') are provided
a surface of said dielectric layer not comprising said conductive layer (9, 9') is pressed against the first surface of the prefabricated product by a perforation die with perforation tips,
whereby holes for microvias are formed in a surface of the dielectric layer, wherein the dielectric layer and the first surface of the prefabricated product are configured and/or coated in a manner that they comprise means for being laminated to each other as a result of being pressed against each other, and
wherein temperature and pressure during the pressing of the dielectric layer against the first surface are chosen in a manner that the prefabricated product and the dielectric layer are laminated to each other.

2. A method according to claim 1, wherein after the perforation step, the perforated surface of the second dielectric layer is further electroplated.

3. A method according to claim 2, wherein after the perforation step and previous to the electroplating step the perforated surface of the second dielectric layer is plasma cleaned.

4. A method according to claim 2 or 3, wherein during the perforation step the conducting layer (9, 9') is pierced.

5. A method according to claim 2 or 3 and wherein the conducting layer (9, 9') comprises openings at the spots where microvias are to be formed so that it is not affected by the perforation.

6. A method according to claim 1, wherein the dielectric layer (11, 11') from which one departs comprises a conducting layer (9, 9') consisting of conducting material, said conducting material during the perforation step being deformed and the dielectric layer (11, 11') material being thrust aside, in a manner that conductor material of the conducting layer is displaced so that it gets into contact with conductor material of an outermost conducting layer of the prefabricated product and is electrically and mechanically connected to conducting material of said second conducting layer.

7. A method according to any one of the preceding claims, wherein at least one of the dielectric layer (11, 11') and of a surface layer of the prefabricated product (1) is made out of an uncured dielectric and wherein this uncured dielectric is cross-linked while pressure is exerted by the perforation die.

8. A method according to any one of the preceding claims wherein at least one of the dielectric layer (11, 11') and of a surface layer of the prefabricated product (1) is made out of thermoplastic material and wherein, while pressure is exerted by the perforation die, it is held at a temperature at which it is softened or melted.

9. A method according to any one of the preceding claims, wherein an additional adhesive is introduced between the dielectric layer (11, 11') and the prefabricated product (1).

10. A method according to any one of the preceding claims, where alignment means are used to define the lateral position of the dielectric layer (11, 11'), the prefabricated product (1) and of the perforation die (23, 25) with respect to each other.

11. A method according to any one of the preceding claims where the combined perforation/lamination step is preceded by a first lamination step.

12. A method according to any one of the preceding claims, where to each of two surfaces of the prefabricated product (1) a dielectric layer (11, 11') is laminated.

13. An electrical connecting element or semifinished product, produced by a method according to any one or the preceding claims.

## Patentansprüche

1. Verfahren zur Herstellung vom elektrischen Verbindungselementen oder Halbfabrikaten, wobei
ein vorgefertigtes Produkt (1) mit einer ersten Oberfläche, welche teilweise mit einer strukturierten elektrisch leitenden Schicht bedeckt ist, und eine dielektrische Schicht (11, 11'), welche eine elektrisch leitende Schicht (9, 9') aufweist, zur Verfügung gestellt werden,
eine Oberfläche der genannten dielektrischen Schicht, welche die genannte leitende Schicht (9, 9') nicht aufweist, durch ein Perforationswerkzeug mit Perforationsspitzen gegen die erste Schicht des vorgefertigten Produkts gepresst wird,
wodurch in der Oberfläche der dielektrischen Schicht Löcher für Mikro-Durchkontaktierungen gebildet werden, wobei die dielektrische Schicht und die erste Schicht des vorgefertigten Produktes in einer Weise ausgebildet und/oder beschichtet sind, dass sie Mittel aufweisen, um, als Folge davon, dass sie gegeneinander gepresst werden, aneinander laminiert zu werden, und wobei Temperatur und Druck während des Pressens der dielektrischen Schicht gegen die erste Schicht derart gewählt werden, dass das vorgefertigte Produkt und die dielektrische Schicht aneinander laminiert werden.

2. Verfahren gemäss Anspruch 1, wobei nach dem Perforationsschritt die perforierte Oberfläche der zweiten dielektrischen Schicht weiter galvanisiert wird.

3. Verfahren gemäss Anspruch 2, wobei die perforierte Oberfläche der zweiten dielektrischen Schicht nach dem Perforationsschritt und vor dem Galvanisierschritt plasmagereinigt wird.

4. Verfahren gemäss Anspruch 2 oder 3, wobei die leitende Schicht (9, 9') während des Perforationsschrittes durchstochen wird.

5. Verfahren gemäss Anspruch 2 oder 3 und wobei die leitende Schicht (9, 9') an den Stellen, wo Mikro-Durchkontaktierungen zu bilden sind Öffnungen aufweist, derart, dass die Perforation sich nicht auf dies auswirkt.

6. Verfahren gemäss Anspruch 1, wobei die dielektrische Schicht (11, 11'), von der ausgegangen wird, eine leitende Schicht (9, 9') bestehend aus leitendem Material aufweist, welches leitende Material während des Perforationschrittes verformt wird und das Material der dielektrischen Schicht (11, 11') zur Seite gedrängt wird, derart, dass das Leitermaterial der leitenden Schicht versetzt wird, sodass es in Kontakt mit Leitermaterial einer äussersten leitenden Schicht des vorgefertigten Produktes kommt und elektrisch und mechanisch mit leitendem Material der besagten leitenden zweiten leitenden Schicht verbunden ist.

7. Verfahren gemäss irgend einem der vorangehenden Ansprüche, wobei mindestens eine der dielektrischen Schicht (11, 11') und eine Oberflächenschicht des vorgefertigten Produktes (1) aus einem unausgehärteten Nichtleiter besteht und wobei dieser unausgehärtete Nichtleiter quervernetzt wird, während Druck durch das Perforationswerkzeug ausgeübt wird.

8. Verfahren gemäss irgend einem der vorangehenden Ansprüche, wobei die dielektrische Schicht (11, 11') und/oder eine Oberflächenschicht des vorgefertigten Produktes (1) aus einem thermoplastischen Material besteht/bestehen und wobei diese während Druck durch das Perforationswerkzeug ausgeübt wird, bei einer Temperatur gehalten wird/werden, bei welcher es/sie erweicht/erweichen oder schmilzt/schmelzen.

9. Verfahren gemäss irgend einem der vorangehenden Ansprüche, wobei ein zusätzliches Haftmittel zwischen der dielektrischen Schicht (11, 11') und dem vorgefertigten Produkt (1) eingeführt wird.

10. Verfahren gemäss irgend einem der vorangehenden Ansprüche, in welchem Ausrichtungsmittel verwendet werden, um die seitliche Position der dielektrischen Schicht (11, 11'), des vorgefertigten Produktes (1) und der Perforationspressform (23, 25) zueinender zu definieren.

11. Verfahren gemäss irgend einem der vorangehenden Ansprüche" in welchem der kombinierte Perforations-/Laminierungsschritt auf einen ersten Laminierungsschritt folgt.

12. Verfahren gemäss irgend einem der vorangehenden Ansprüche, in welchem an jede der zwei Oberflächen des vorgefertigten Produktes (1) eine dielektrische Schicht (11, 11') laminiert wird.

13. Elektrisches Verbindungselement oder Halbfabrikat, hergestellt nach einem Verfahren gemäss irgend einem der vorangehenden Ansprüche

## Revendications

1. Procédé pour fabriquer des éléments de connexion électrique ou des produits semi-finis, dans lequel :
on prévoit un produit préfabriqué (1) dont une première surface est partiellement couverte par une couche structurée électriquement conductrice et par une couche diélectrique (11, 11') qui comprend une couche électriquement conductrice (9, 9'),
une surface de ladite couche diélectrique qui ne comprend pas ladite couche conductrice (9, 9') est pressée contre la première surface du produit préfabriqué à l'aide d'un poinçon de perforation doté de pointes de perforation,
grâce à quoi des trous prévus pour des micropassages sont formés dans une surface de la couche diélectrique,
la couche diélectrique et la première surface du produit préfabriqué étant configurées et/ou recouvertes de manière à comprendre des moyens qui les stratifient les uns sur les autres lorsqu'ils sont repoussés les uns contre les autres, la température et la pression pendant le pressage de la couche diélectrique contre la première surface étant sélectionnées de telle sorte que le produit préfabriqué et la couche diélectrique soient stratifiés l'un sur l'autre.

2. Procédé selon la revendication 1, dans lequel la surface perforée de la deuxième couche diélectrique est de plus plaquée électrolytiquement après l'étape de perforation.

3. Procédé selon la revendication 2, dans lequel la surface perforée de la deuxième couche diélectrique est nettoyée au plasma après l'étape de perforation et avant l'étape de placage électrolytique.

4. Procédé selon les revendications 2 ou 3, dans lequel la couche conductrice (9, 9') est percée pendant l'étape de perforation.

5. Procédé selon les revendications 2 ou 3, dans lequel la couche conductrice (9, 9') comprend des ouvertures aux emplacements où les micropassages doivent être formés, de telle sorte que la couche conductrice ne soit pas affectée par la perforation.

6. Procédé selon la revendication 1, dans lequel la couche diélectrique (11,11') de laquelle on part comprend une couche conductrice (9, 9') constituée d'un matériau conducteur, ledit matériau conducteur étant déformé au cours de l'étape de perforation et le matériau de la couche (11, 11') diélectrique étant repoussé sur le côté de telle sorte que le matériau conducteur de la couche conductrice soit déplacé de manière à être mis en contact avec le matériau conducteur d'une couche conductrice externe du produit préfabriqué et à être électriquement et mécaniquement relié au matériau conducteur de ladite deuxième couche conductrice.

7. Procédé selon l'une quelconque des revendications précédentes, dans lequel la couche diélectrique (11, 11') et/ou une couche de surface du produit préfabriqué (1) sont réalisées en un diélectrique non durci et dans lequel ce diélectrique non durci est réticulé pendant que la pression est exercée par le poinçon de perforation.

8. Procédé selon l'une quelconque des revendications précédentes, dans lequel la couche diélectrique (11, 11') et/ou la couche de surface du produit préfabriqué (1) sont réalisées en matériau thermoplastique qui est maintenu à une température à laquelle il est souple ou fondu lorsque la pression est exercée par le poinçon de perforation.

9. Procédé selon l'une quelconque des revendications précédentes, dans lequel un adhésif supplémentaire est introduit entre la couche diélectrique (11, 11') et le produit préfabriqué (1).

10. Procédé selon l'une quelconque des revendications précédentes, dans lequel des moyens d'alignement sont utilisés pour définir la position latérale de la couche diélectrique (11, 11'), du produit préfabriqué (1) et du poinçon de perforation (23, 25) les uns par rapport aux autres.

11. Procédé selon l'une quelconque des revendications précédentes, dans lequel l'étape combinée de perforation et de stratification est précédée par une première étape de stratification.

12. Procédé selon l'une quelconque des revendications précédentes, dans lequel une couche diélectrique (11, 11') est stratifiée pour chacune des deux surfaces du produit préfabriqué (1).

13. Elément de connexion électrique ou produit semi-fini produits par un procédé selon l'une quelconque des revendications précédentes.
